# EUROPEAN PATENT APPLICATION

(11) **EP 2 610 540 A1**
(43) Date of publication of application: **03.07.2013**
(21) Application number: 11819677.3
(22) Date of filing: 29.06.2011
(51) Int. Cl.: F21S 2/00, F21V 7/22, G02F 1/13357, F21Y 101/02

(54) **WAVELENGTH CONVERSION ELEMENT, LIGHT SOURCE, AND BACKLIGHT UNIT FOR LIQUID CRYSTALS**

(30) Priority: 01.11.2010 JP 2010245366; 26.08.2010 JP 2010189407
(71) Applicant: Nippon Electric Glass Co., Ltd., Otsu-shi Shiga 520-8639 (JP)
(72) Inventor: KADOMI, Masaaki, Otsu-shi Shiga 520-8639 (JP); YAMAGUCHI, Yoshimasa, Otsu-shi Shiga 520-8639 (JP); NISHIMIYA, Takahumi, Otsu-shi Shiga 520-8639 (JP)
(74) Representative: Ter Meer Steinmeister & Partner
(86) International application number: PCT/JP2011/064909
(87) International publication number: WO 2012/026206

(57) **Abstract**

Provided is a wavelength conversion element that can prevent damage to the wavelength conversion element during the use of the light source and reduce the decrease in intensity of light emitted from the light source equipped with the wavelength conversion element during the use of the light source. The wavelength conversion element 20 includes a wavelength conversion substrate 21 and a reflective layer 24. The wavelength conversion substrate 21, upon incidence of excitation light L0, absorbs part of the excitation light L0 to emit light of different wavelength from the excitation light L0. The reflective layer 24 is disposed on one surface 21b of the wavelength conversion substrate 21. The reflective layer 24 is made of a metal or an alloy.

## Description

### Technical Field

This invention relates to wavelength conversion elements, light sources therewith, and backlight units for liquid crystals.

### Background Art

In recent years, much development has been made of white light sources for use in, for example, backlights of liquid crystal displays, as well as other applications. For example, Patent Literature 1 below discloses, as an example of such a white light source, a light source in which a wavelength-converting member is disposed on a light-emitting side of an LED (light emitting diode) for emitting a blue light and absorbs part of the light from the LED to emit a yellow light. Emitted from this light source is a white light which is a synthesized light of the blue light emitted from the LED and then having transmitted through the wavelength-converting member and the yellow light emitted from the wavelength-converting member.

### Citation List

### Patent Literature

Patent Literature 1: JP-A 2005-209852

### Summary of Invention

### Technical Problem

However, intensive studies of the inventors have revealed that in such a light source that includes a plurality of LEDs arranged therein, there arise problems in that during the use of the light source, the wavelength conversion element is damaged and the intensity of emitted light is decreased with time.

The present invention has been made in view of the above points and an object thereof is to provide a wavelength conversion element that can prevent damage to the wavelength conversion element during the use of the light source and reduce the decrease in intensity of light emitted from the light source equipped with the wavelength conversion element during the use of the light source.

### Solution to Problem

A wavelength conversion element according to the present invention includes a wavelength conversion substrate and a reflective layer. The wavelength conversion substrate, upon incidence of excitation light, absorbs part of the excitation light to emit light of different wavelength from the excitation light. The reflective layer is disposed on one surface of the wavelength conversion substrate. The reflective layer is made of a metal or an alloy.

Note that the term "substrate" in the present invention includes a sheet-like or film-like member.

The wavelength conversion element according to the present invention preferably further includes a reflection suppression layer formed on the other surface of the wavelength conversion substrate to suppress the reflection of light entering the wavelength conversion substrate through the other surface thereof.

In the wavelength conversion element according to the present invention, the reflection suppression layer is preferably formed of a stack including a low-refractive index layer of relatively low refractive index and a high-refractive index layer of relatively high refractive index alternately stacked.

In the wavelength conversion element according to the present invention, the reflective layer is preferably made of a metal selected from the group consisting of Ag, Al, Au, Pd, and Ti or an alloy containing at least one metal selected from the group consisting of Ag, Al, Au, Pd, and Ti.

The wavelength conversion element according to the present invention preferably further includes an adhesion layer formed between the reflective layer and the wavelength conversion substrate to increase the adhesion strength between the reflective layer and the wavelength conversion substrate.

In the wavelength conversion element according to the present invention, the adhesion layer is preferably made of aluminum oxide, chromium oxide, copper oxide, titanium, chromium or an alloy containing chromium.

The wavelength conversion element according to the present invention preferably further includes a solder securing layer formed on the reflective layer.

The solder securing layer is preferably made of Au, an alloy containing Au, Sn, an alloy containing Sn, In, an alloy containing In, Pb, an alloy containing Pb, Al, an alloy containing Al, Ag or an alloy containing Ag.

The wavelength conversion element according to the present invention preferably further includes a barrier layer formed between the solder securing layer and the reflective layer and made of Ni, a Ni-Cr alloy, Pt or Pd.

In the wavelength conversion element according to the present invention, the wavelength conversion substrate is preferably made of a glass or ceramic containing inorganic phosphor powder dispersed therein.

A light source according to the present invention includes the wavelength conversion element according to the present invention and a light-emitting element for emitting excitation light to the other surface of the wavelength conversion substrate.

In the light source according to the present invention, the light-emitting element is preferably formed of a semiconductor light-emitting element.

In the light source according to the present invention, the wavelength conversion element preferably further includes a solder securing layer formed on the reflective layer and made of Au, an alloy containing Au, Sn or an alloy containing Sn. In this case, the light source according to the present invention preferably further includes a housing and a solder layer that bonds the housing and the solder securing layer of the wavelength conversion substrate together.

A backlight unit for liquid crystals according to the present invention includes the light source according to the present invention and a light guide. The light guide includes a principal surface and a side surface. The light guide receives on the side surface light from the wavelength conversion element and emits the light as area light from the principal surface. Advantageous Effects of Invention

The present invention can provide a wavelength conversion element that can prevent damage to the wavelength conversion element during the use of the light source and reduce the decrease in intensity of light emitted from the light source equipped with the wavelength conversion element during the use of the light source.

### Brief Description of Drawings

[Fig. 1] Fig. 1 is a schematic view of a light source according to an embodiment for working of the present invention.
[Fig. 2] Fig. 2 is a schematic cross-sectional view of a wavelength conversion element in the embodiment for working of the present invention.
[Fig. 3] Fig. 3 is a schematic cross-sectional view of a reflection suppression layer.
[Fig. 4] Fig. 4 is a schematic view of a light source according to a modification.
[Fig. 5] Fig. 5 is a schematic view of a backlight unit for liquid crystals according to a second embodiment.
[Fig. 6] Fig. 6 is a schematic view of a backlight unit for liquid crystals according to a third embodiment.
[Fig. 7] Fig. 7 is a schematic view of a backlight unit for liquid crystals according to a fourth embodiment. Description of Embodiments

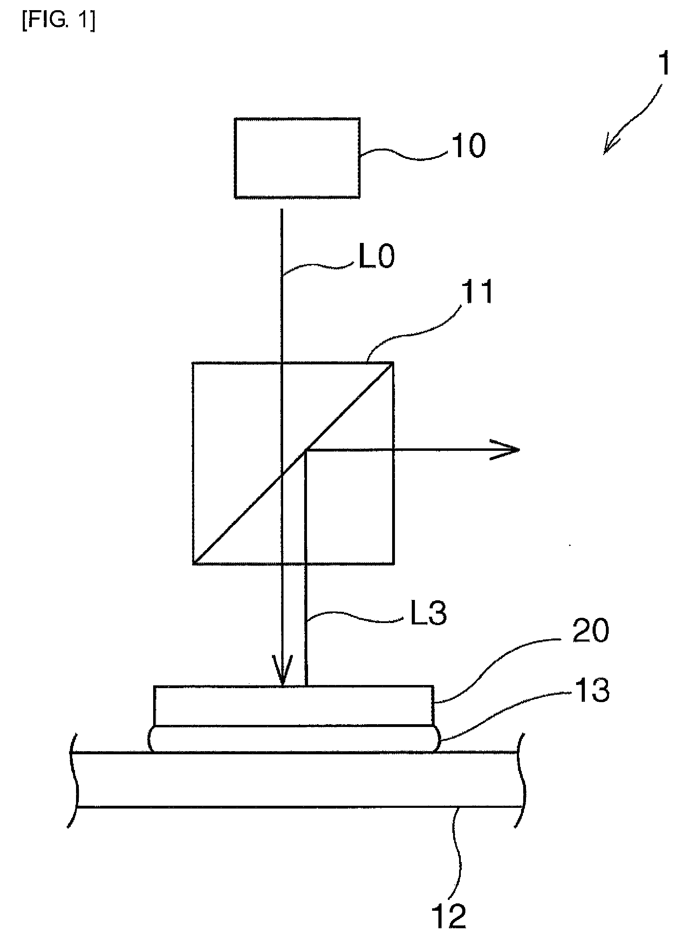

Hereinafter, a description will be given of a preferred embodiment for working of the present invention taking as an example a light source 1 shown in Fig. 1. However, the light source 1 and a wavelength conversion element 20 contained in the light source 1 are simply illustrative. The light source and wavelength conversion element according to the present invention are not at all limited to the light source 1 and the wavelength conversion element 20.

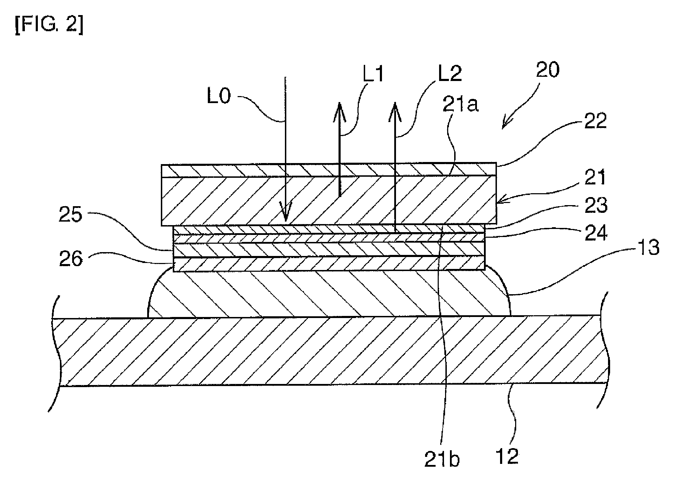

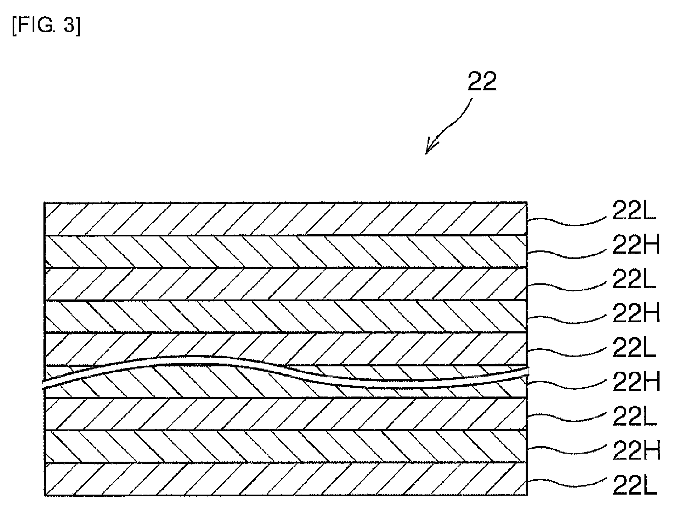

Fig. 1 is a schematic view of a light source according to this embodiment. Fig. 2 is a schematic cross-sectional view of a wavelength conversion element in this embodiment. Fig. 3 is a schematic cross-sectional view of a reflection suppression layer in this embodiment.

As shown in Fig. 1, the light source 1 includes a light-emitting element 10, a wavelength conversion element 20, a dichroic mirror 11, and a housing 12. The light-emitting element 10, the dichroic mirror 11, and the wavelength conversion element 20 are contained in the housing 12 and fixed. No particular limitation is placed on the type of the housing 12 so long as it can hold the light-emitting element 10, the dichroic mirror 11, and the wavelength conversion element 20. The housing 12 can be made of, for example, resin, metal or alloy. Particularly, the housing 12 is preferably made of a material having high thermal conductivity, such as metal or alloy. Specifically, the housing 12 is preferably made of, for example, such a metal as iron, aluminum or copper or such an alloy as stainless steel.

The light-emitting element 10 emits excitation light for the wavelength conversion element 20 toward the wavelength conversion element 20. No particular limitation is placed on the type of the light-emitting element 10 so long as it can emit excitation light. The light-emitting element 10 can be formed of, for example, an LED (light emitting diode), a laser light-emitting element, an EL (electroluminescent) light-emitting element or a plasma light-emitting element.

As shown in Fig. 2, the wavelength conversion element 20 includes a wavelength conversion substrate 21. The wavelength conversion substrate 21 has first and second principal surfaces 21a, 21b. The wavelength conversion substrate 21 is placed so that the first principal surface 21a is oriented to the light-emitting element 10 (see Fig. 1) and excitation light L0 emitted from the light-emitting element 10 thus enters the first principal surface 21a.

The wavelength conversion substrate 21 contains a phosphor that can absorb the excitation light L0 to emit light of different wavelength from the absorbed excitation light. Specifically, in this embodiment, the wavelength conversion substrate 21 is made of a glass containing inorganic phosphor powder dispersed therein. Therefore, the wavelength conversion substrate 21 absorbs part of the excitation light L0 to emit light of different wavelength from the absorbed excitation light. Because the inorganic phosphor powder and the glass have high thermal resistance, the formation of the wavelength conversion substrate 21 from the glass containing inorganic phosphor powder dispersed therein can achieve high thermal resistance of the wavelength conversion substrate 21.

Although no particular limitation is placed on the thickness of the wavelength conversion substrate 21, it can be, for example, about 0.5 mm to about 3.0 mm. If the wavelength conversion substrate 21 is too thick, the proportion of the part of the excitation light L0 absorbed by the wavelength conversion substrate 21 to the total excitation light L0 will be large so that the intensity of reflected light L2 may be too low. On the other hand, if the wavelength conversion substrate 21 is too thin, the intensity of fluorescence L1 may be too low.

Note that the type of inorganic phosphor powder can be appropriately selected depending upon the wavelength of light L3 to be emitted from the light source 1, the wavelength of the excitation light L0 emitted from the light-emitting element 10, and so on. The inorganic phosphor powder can be made of one or more phosphors selected from, for example, oxide inorganic phosphors, nitride inorganic phosphors, oxynitride inorganic phosphors, sulfide inorganic phosphors, oxysulfide inorganic phosphors, rare-earth sulfide inorganic phosphors, aluminic acid chloride inorganic phosphors, and halophosphoric acid chloride inorganic phosphors.

Examples of the inorganic phosphor powder which produces a blue visible light (fluorescence having a wavelength of 440 nm to 480 nm) upon irradiation with an ultraviolet to near-ultraviolet excitation light having a wavelength of 300 to 440 nm include Sr₅(PO₄)₃Cl: Eu²⁺, (Sr,Ba)MgAl₁₀O₁₇:Eu²⁺, and (Sr, Ba)₃MgSi₂O₈: Eu²⁺.

Examples of the inorganic phosphor powder which produces a green visible light (fluorescence having a wavelength of 500 nm to 540 nm) upon irradiation with an ultraviolet to near-ultraviolet excitation light having a wavelength of 300 to 440 nm include SrAl₂O₄: Eu²⁺, SrGa₂S₄: Eu²⁺, SrBaSiO₄: Eu²⁺, CdS: In, CaS: Ce³⁺, Y₃(Al,Gd)₅O₁₂: Ce²⁺, Ca₃Sc₂Si₃O₁₂:Ce³⁺, SrSiOn: Eu²⁺, ZnS: Al³⁺, Cu⁺, CaS: Sn²⁺, CaS: Sn²⁺, F, CaSO₄: Ce³⁺, Mn²⁺, LiAlO₂: Mn²⁺, BaMgAl₁₀O₁₇: Eu²⁺, Mn²⁺, ZnS: Cu⁺, Cl⁻, Ca₃WO₆: U, Ca₃SiO₄Cl₂: Eu²⁺, Sr_{0.2}Ba_{0.7}Cl_{1.1}Al₂O_{3.45}:Ce³⁺, Mn²⁺, Ba₂MgSi₂O₇: Eu²⁺, Ba₂SiO₄: Eu²⁺, Ba₂Li₂Si₂O₇: Eu²⁺, ZnO: S, ZnO: Zn, Ca₂Ba₃(PO₄)₃Cl: Eu²⁺, and BaAl₂O₄: Eu²⁺.

Examples of the inorganic phosphor powder which produces a green visible light (fluorescence having a wavelength of 500 nm to 540 nm) upon irradiation with a blue excitation light having a wavelength of 440 to 480 nm include SrAl₂O₄:Eu²⁺, SrGa₂S₄: Eu²⁺, SrBaSiO₄:Eu²⁺, CdS: In, CaS:Ce³⁺, Y₃(Al, Gd)₅O₁₂:Ce²⁺, Ca₃Sc₂Si₃O₁₂: Ce³⁺, and SrSiOn:Eu²⁺.

Examples of the inorganic phosphor powder which produces a yellow visible light (fluorescence having a wavelength of 540 nm to 595 nm) upon irradiation with an ultraviolet to near-ultraviolet excitation light having a wavelength of 300 to 440 nm include ZnS:Eu²⁺, Ba₅(PO₄)₃Cl:U, Sr₃WO₆: U, CaGa₂S₄: Eu²⁺, SrSO₄: Eu²⁺, Mn²⁺, ZnS: P, ZnS: P³⁻, Cl⁻, and ZnS: Mn²⁺.

Examples of the inorganic phosphor powder which produces a yellow visible light (fluorescence having a wavelength of 540 nm to 595 nm) upon irradiation with a blue excitation light having a wavelength of 440 to 480 nm include Y₃(Al,Gd)₅O₁₂: Ce²⁺, Ba₅(PO₄)₃Cl: U, CaGa₂S₄: Eu²⁺, and Sr₂SiO₄: Eu²⁺.

Examples of the inorganic phosphor powder which produces a red visible light (fluorescence having a wavelength of 600 nm to 700 nm) upon irradiation with an ultraviolet to near-ultraviolet excitation light having a wavelength of 300 to 440 nm include CaS: Yb²⁺, Cl, Gd₃Ga₄O₁₂: Cr³⁺, CaGa₂S₄: Mn²⁺, Na(Mg,Mn)₂LiSi₄O₁₀F₂: Mn, ZnS: Sn²⁺, Y₃Al₅O₁₂: Cr³⁺, SrB₈O₁₃: Sm²⁺, MgSr₃Si₂O₈: Eu²⁺, Mn²⁺, α-SrO·3B₂O₃: Sm²⁺, ZnS-CdS, ZnSe: Cu⁺, Cl, ZnGa₂S₄: Mn²⁺, ZnO: Bi³⁺, BaS: Au, K, ZnS: Pb²⁺, ZnS: Sn²⁺, Li⁺, ZnS: Pb, Cu, CaTiO₃: Pr³⁺, CaTiO₃: Eu³⁺, Y₂O₃: Eu³⁺, (Y,Gd)₂O₃: Eu³⁺, GaS: Pb²⁺, Mn²⁺, YPO₄: Eu³⁺, Ca₂MgSi₂O₇: Eu²⁺, Mn²⁺, Y(P,V)O₄: Eu³⁺, Y₂O₂S: Eu³⁺, SrAl₄O₇: Eu³⁺, CaYAlO₄: Eu³⁺, LaO₂S: Eu³⁺, LiW₂O₈: Eu³⁺, Sm³⁺, (Sr,Ca,Ba,Mg)₁₀(PO₄)₆Cl₂: Eu²⁺, Mn²⁺, and Ba₃MgSi₂O₈:Eu²⁺,Mn²⁺.

Examples of the inorganic phosphor powder which produces a red visible light (fluorescence having a wavelength of 600 nm to 700 nm) upon irradiation with a blue excitation light having a wavelength of 440 to 480 nm include ZnS:Mn²⁺,Te²⁺, Mg₂TiO₄:Mn⁴⁺, K₂SiF₆:Mn⁴⁺, SrS:Eu²⁺, CaS:Eu²⁺, Na_{1.23}K_{0.42}Eu_{0.12}TiSi₄O₁₁, Na_{1.23}K_{0.42}Eu_{0.12}TiSi₅O₁₃:Eu³⁺, CdS:In,Te, CaAlSiN₃:Eu²⁺, CaSiN₃:Eu²⁺, (Ca,Sr)₂Si₅N₈:Eu²⁺, and Eu₂W₂O₇.

A plurality of inorganic phosphor powders may be used in combination depending upon the wavelength range of the excitation light or the luminescence. For example, if a white light is to be produced by irradiation with an ultraviolet excitation light, respective inorganic phosphor powders capable of producing blue, green, and red fluorescences can be used in combination.

No particular limitation is placed on the dispersion medium for the inorganic phosphor powder. Examples of the dispersion medium include, for example, glass, ceramic, and resin.

No particular limitation is placed on the type of glass as the dispersion medium so long as it can stably hold inorganic phosphor powder. Specific examples of the glass that can be used as the dispersion medium include silicate glasses; borate glasses; borosilicate glasses, such as SiO₂-B₂O₃-RO glasses (where R is at least one of Mg, Ca, Sr, and Ba) ; phosphate glasses, such as SnO-P₂O₅ glasses; and borophosphate glasses. Particularly, SiO₂-B₂O₃-RO glasses and SnO-P₂O₅ glasses are preferably used.

Specific examples of the ceramic as the dispersion medium include alumina, zirconia, barium titanate, silicon nitride, and metal nitrides, such as titanium nitride.

Although no particular limitation is placed on the content of inorganic phosphor powder in the wavelength conversion substrate 21, it is, for example, preferably 0.01% by mass to 95% by mass, more preferably 10% by mass to 90% by mass, and particularly preferably 50% by mass to 90% by mass. As shown in Fig. 2, a reflective layer 24 made of a metal or alloy is formed on the second principal surface 21b of the wavelength conversion substrate on the opposite side to the light-emitting element 10. Thus, in this embodiment, the reflective layer 24 reflects, toward the light-emitting element 10, part of the excitation light L0 having not been absorbed by the wavelength conversion substrate 21 and part of fluorescence produced in the wavelength conversion substrate 21 and then emitted to the reflective layer 24. Therefore, when the excitation light L0 enters the wavelength conversion substrate 21, fluorescence L1 produced by the inorganic phosphor powder having absorbed the excitation light L0 and reflected light L2 of the excitation light L0 are emitted from the first principal surface 21a of the wavelength conversion substrate 21 toward the light-emitting element 10. Hence, light L3 emitted from the wavelength conversion substrate 21 shown in Fig. 1 toward the light-emitting element 10 is synthesized light of the fluorescence L1 and the reflected light L2. Accordingly, with the use of an LED for emitting a blue light as the light-emitting element 10 and the use of the wavelength conversion element 20 for absorbing a blue light and producing a yellow light, a white light source 1 useful as, for example, a light source for a liquid crystal display can be achieved. Note that the synthesized light L3 is reflected by the dichroic mirror 11 and thus extracted in a direction different from the light-emitting element 10.

No particular limitation is placed on the material of the reflective layer 24 so long as it is a metal or alloy that can reflect the excitation light L0. Examples of such a metal and an alloy to be preferably used for the formation of the reflective layer 24 are a metal selected from the group consisting of Ag, Al, Au, Pd, and Ti and an alloy containing at least one of these metals, such as an Ag-Pd alloy. Particularly, the reflective layer 24 is preferably made of a metal, such as Ag or A1, or an alloy containing at least one of Ag and Al. In this case, the optical reflectance of the reflective layer 24 can be increased to increase the intensity of the synthesized light L3 emitted from the light source 1. This embodiment will hereinafter be described with reference to an example in which the reflective layer 24 is made of Ag.

No particular limitation is placed on the thickness of the reflective layer 24 so long as it is a thickness that allows suitable reflection of the excitation light L0. The thickness of the reflective layer 24 can be, for example, about 100 nm to about 300 nm. If the thickness of the reflective layer 24 is too small, the reflectance of the excitation light L0 may be too low. On the other hand, if the thickness of the reflective layer 24 is too large, this may cause effects of increased film stress and surface scattering.

Meanwhile, a reflection suppression layer 22 is formed on the first principal surface 21a of the wavelength conversion substrate 21. By controlling the film thickness of this reflection suppression layer 22, the excitation light L0 entering through the first principal surface 21a is suppressed in terms of reflection at the first principal surface 21a. In addition, the fluorescence L1 and the reflected light L2 are also suppressed in terms of reflection at the first principal surface 21a. As a result, the utilization efficiency of the excitation light L0 can be increased to increase the intensity of the synthesized light L3.

No particular limitation is placed on the type of the reflection suppression layer 22 so long as it can suppress the reflection of the excitation light L0 at the first principal surface 21a. The reflection suppression layer 22, for example, as shown in Fig. 3, can be formed of a stack including low-refractive index layers 22L and high-refractive index layers 22H alternately stacked. Here, the low-refractive index layer 22L is a layer having a relatively low refractive index. The low-refractive index layer 22L can be made of, for example, silicon oxide or magnesium fluoride. The high-refractive index layer 22H is a layer having a relatively high refractive index. The high-refractive index layer 22H can be made of, for example, tantalum oxide, yttrium oxide, zirconium oxide, aluminum oxide, niobium oxide, titanium oxide or hafnium oxide. Note that the refractive index of the high-refractive index layer 22H is preferably 0.1 or more different from that of the low-refractive index layer 22L. Although no particular limitation is placed on the total number of the low-refractive index layers 22L and the high-refractive index layers 22H, it is, for example, preferably about 2 to about 50, more preferably about 4 to about 20, and still more preferably about 4 to about 10. If the total number of the low-refractive index layers 22L and the high-refractive index layers 22H is too small, the effect of reflection suppression may not be sufficiently achieved. On the other hand, if the total number of the low-refractive index layers 22L and the high-refractive index layers 22H is too large, the film stress will be increased so that they may be likely to be peeled. In addition, the time for the formation of the low-refractive index layers 22L and the high-refractive index layers 22H may be too long.

The thickness of each of the low-refractive index layer 22L and the high-refractive index layer 22H can be appropriately set depending upon the wavelength to be suppressed in terms of reflection. The thickness of each of the low-refractive index layer 22L and the high-refractive index layer 22H can be, for example, about 10 nm to about 200 nm.

An adhesion layer 23 is formed between the reflective layer 24 and the wavelength conversion substrate 21. The adhesion layer 23 is a layer having higher adhesion strength thereof to the reflective layer 24 than that of the reflective layer 24 to the wavelength conversion substrate 21 and higher adhesion strength thereof to the wavelength conversion substrate 21 than that of the reflective layer 24 to the wavelength conversion substrate 21. Therefore, this adhesion layer 23 increases the adhesion strength between the reflective layer 24 and the wavelength conversion substrate 21. No particular limitation is placed on the type of the adhesion layer 23 so long as it can increase the adhesion strength between the reflective layer 24 and the wavelength conversion substrate 21. The adhesion layer 23 can be made of, for example, aluminum oxide, chromium oxide, copper oxide, titanium, chromium or an alloy containing chromium. A specific example of the alloy containing chromium is a Ni-Cr alloy.

Note that if the adhesion layer 23 is made of an oxide, such as aluminum oxide, chromium oxide or copper oxide, the thickness of the adhesion layer 23 can be, for example, about 5 nm to about 500 nm. If the adhesion layer 23 is too thin, the effect of increasing the adhesion strength may not be sufficiently achieved. On the other hand, if the thickness of the adhesion layer 23 is too thick, the film stress will be increased so that the adhesion layer 23 may be peeled. Particularly if made of chromium oxide or copper oxide, the excessively thick adhesion layer 23 will excessively absorb light so that the intensity of reflected light may be decreased.

If the adhesion layer 23 is made of a metal, such as titanium or chromium, or an alloy containing chromium, the thickness of the adhesion layer 23 is, for example, preferably not more than 10 nm. If the adhesion layer 23 is too thick, the adhesion layer 23 will excessively absorb light so that the intensity of reflected light may be decreased. On the other hand, if the adhesion layer 23 is too thin, the effect of increasing the adhesion strength may not be sufficiently achieved. Therefore, if the adhesion layer 23 is made of a metal, such as titanium or chromium, or an alloy containing chromium, the thickness of the adhesion layer 23 is, for example, preferably not less than 0.1 nm.

Furthermore, if Al having high adhesion strength is used as the reflective layer 24, there is no need to form the adhesion layer 23 between the reflective layer (Al) and the wavelength conversion substrate 21.

Laid through a barrier layer 25 on the reflective layer 24 is a solder securing layer 26 which is made of Au, an alloy containing Au, Sn or an alloy containing Sn and has high solder wettability. Furthermore, the solder securing layer 26 is bonded to the housing 12 by a solder layer 13 which may be made of various solders, such as a Sn alloy. Here, the solder securing layer 26 is a layer for increasing the bonding strength of the solder layer 13. The thickness of the solder securing layer 26 can be, for example, about 100 nm to about 500 nm. If the thickness of the solder securing layer 26 is too small, the wettability may be decreased. On the other hand, if the thickness of the solder securing layer 26 is too large, the productivity may be decreased.

The barrier layer 25 is formed of Ni, a Ni-Cr alloy layer made of a Ni-Cr alloy, a Pt layer made of Pt, or a Pd layer made of Pd. By this barrier layer 25, it can be effectively prevented that upon soldering with a solder the reflective layer 24 is damaged by the solder. The thickness of the barrier layer 25 can be, for example, about 100 nm to about 2000 nm. If the thickness of the barrier layer 25 is too small, the barrier effect may not be sufficiently achieved and thus may damage the reflective layer 24. On the other hand, if the thickness of the barrier layer 25 is too large, the film stress thereof may break the solder securing layer 26.

Note that if the barrier layer 25 is made of a Ni-Cr alloy, the molar ratio between Ni and Cr (Ni/Cr) can be not less than 50 but less than 100.

As described previously, in this embodiment, the reflective layer 24 made of a metal or alloy is provided. Therefore, as will also be demonstrated by an example and comparative example below, the decrease in intensity of the synthesized light L3 during the use of the light source 1 can be effectively reduced. The reason why this effect can be achieved can be that the formation of the reflective layer 24 with high thermal conductivity made of a metal or alloy on the second principal surface reduces the thermal quenching of luminescence due to temperature rise of the wavelength conversion substrate 21. Particularly in this embodiment, the barrier layer 25, the solder securing layer 26, and the solder layer 13 which are made of a metal or alloy and have high thermal conductivity are formed on the reflective layer 24. It can be believed that, therefore, the heat radiation property is further increased to more effectively reduce the thermal quenching of luminescence due to temperature rise of the wavelength conversion substrate 21.

Furthermore, from the viewpoint of more effectively reducing thermal quenching, the housing 12 is preferably made of a material having high thermal conductivity, such as metal or alloy. Instead of the solder layer 13, an inorganic adhesive layer made of a hardened product of an inorganic adhesive, for example, may be provided. In this case, the barrier layer 25 and the solder securing layer 26 may not necessarily be provided.

The above effect of this embodiment can be believed to be achieved regardless of the type of the light-emitting element 10. Yet the effect can be considered to be more significantly exerted where a semiconductor light-emitting element 10 easily producing heat, such as a high-power LED or a laser element, is used so that the wavelength conversion substrate 21 will be easily raised in temperature.

Note that the formation of such a low-transmittance reflective layer 24 made of a metal or alloy on the second principal surface 21b of this wavelength conversion substrate 21 is implemented only by using the wavelength conversion element 20 which is not of transmission type but of reflection type.

The above embodiment has described the case where the wavelength conversion substrate 21 is made of inorganic materials, i . e . , glass and inorganic phosphor powder. However, the present invention is not limited to this. For example, phosphor powder made of an organic material may be used or the dispersion medium for phosphor powder may be a ceramic or organic resin.

The above embodiment has described an example in which the synthesized light L3 is extracted using the dichroic mirror 11. However, the present invention is not limited to this configuration. For example, the light source may be configured, without using the dichroic mirror 11, by disposing the light-emitting element 10 so that the excitation light L0 obliquely enters the wavelength conversion substrate 21.

Hereinafter, a description will be given of another exemplary preferred embodiments and modifications for working of the present invention. In the following description, elements having substantially the same functions as those in the above embodiment are referred to by the common reference numerals and further explanation thereof will be omitted.

### (Modification)

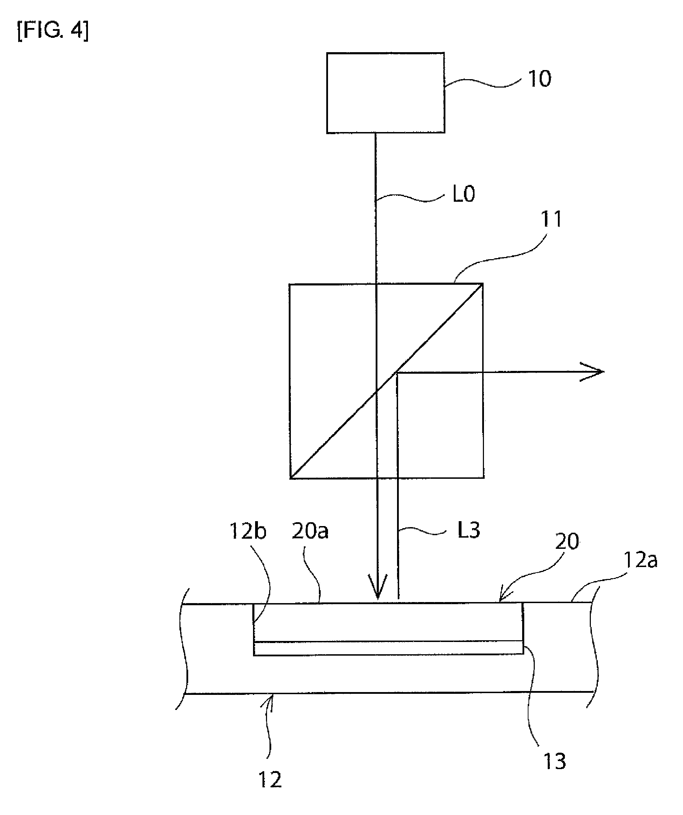

Fig. 4 is a schematic view of a light source according to this modification. As shown in Fig. 4, in this modification, a recess 12b is formed in the surface 12a of the housing 12. The wavelength conversion element 20 is placed in the recess 12b. The surface 20a of the wavelength conversion element 20 is flush with the surface 12a of the housing 12. Thus, in this modification, the side surfaces of the wavelength conversion element 20 are covered by the housing 12. Therefore, the light emission from the side surfaces of the wavelength conversion element 20 is prevented. Hence, the intensity of light emitted from the surface 20a of the wavelength conversion element 20 can be increased. As a result, the intensity of the emitted light L3 can be increased.

### (Second Embodiment)

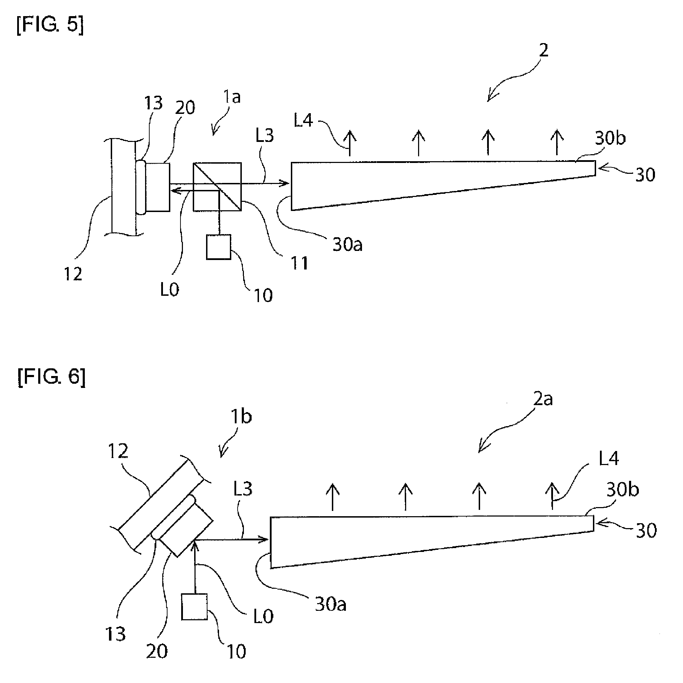

Fig. 5 is a schematic view of a backlight unit for liquid crystals according to a second embodiment. The backlight unit 2 for liquid crystals in this embodiment is used as a backlight unit for a liquid crystal display.

The backlight unit 2 for liquid crystals includes a light source 1a and a light guide 30. The light source 1a includes a light-emitting element 10, a dichroic mirror 11, and a wavelength conversion element 20 mounted to a housing 12 by a solder layer 13. Excitation light L0 emitted from the light source 10 is guided to the wavelength conversion element 20 by the dichroic mirror 11. On the other hand, light L3 which is synthesized light of fluorescence and reflected light transmits through the dichroic mirror 11. The light L3 having transmitted through the dichroic mirror 11 enters the light guide 30 through a side surface 30a thereof. The light having entered the light guide 30 is guided inside the light guide 30 and emitted as area light L4 from a principal surface 30b.

Also in this embodiment, a reflective layer made of a metal or alloy is provided. Therefore, the decrease in intensity of the synthesized light L3 during the use of the backlight unit 2 for liquid crystals can be effectively reduced.

### (Third and Fourth Embodiments)

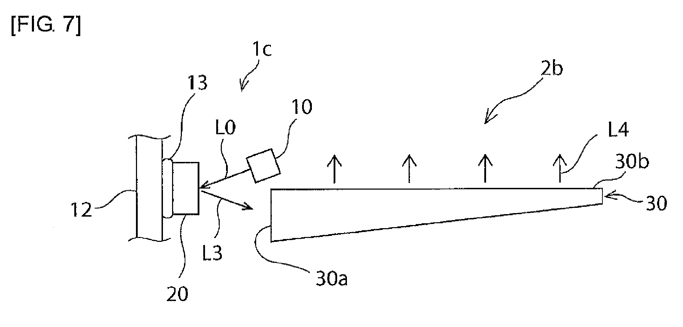

Fig. 6 is a schematic view of a backlight unit for liquid crystals according to a third embodiment. Fig. 7 is a schematic view of a backlight unit for liquid crystals according to a fourth embodiment.

The backlight units 2a, 2b for liquid crystals in the third and fourth embodiments are different only in the configuration of the light source from the backlight unit 2 for liquid crystals in the second embodiment. As shown in Figs. 6 and 7, light sources 1b, 1c used in the third and fourth embodiments include no dichroic mirror 11. In the third and fourth embodiments, a light-emitting element 10 and a wavelength conversion element 20 are disposed so that light L0 emitted from the light-emitting element 10 directly enters the wavelength conversion element 20 and light L3 emitted from the wavelength conversion element 20 directly enters a side surface 30a of a light guide 30.

The present invention will be described below in further detail with reference to a specific example. However, the present invention is not at all limited to the following example and modifications and variations may be appropriately made therein without changing the gist of the invention.

### (Example)

First, 15% by mass phosphor powder of CaS:Ce³⁺ was added to 85% by mass glass powder of borosilicate-based glass, followed by mixing and then firing, resulting in production of a 0.2 mm thick wavelength conversion substrate.

Next, formed on one surface of the produced wavelength conversion substrate was a 250 nm thick reflection suppression layer in which low-refractive index layers were made of silicon oxide and high-refractive index layers were made of tantalum oxide.

Furthermore, an adhesion layer of aluminum oxide was formed with a thickness of 134 nm on the opposite surface of the substrate to the surface thereof on which the reflection suppression layer was formed, and a reflective layer made of Ag was formed with a thickness of 200 nm on the adhesion layer. Subsequently, a barrier layer made of a Ni-Cr alloy was formed with a thickness of 500 nm on the reflective layer and a solder securing layer made of Au was formed with a thickness of 300 nm on the barrier layer, resulting in production of a wavelength conversion element (of reflection type).

The produced wavelength conversion element and a housing made of a metal were bonded together using a solder and the wavelength conversion element was disposed so that light was applied to the surface thereof at which the reflection suppression layer was formed. This wavelength conversion element was continuously irradiated for 30 minutes with laser light (of 440 nm to 450 nm wavelength) operated with a current of 30 mA, the light emitted therefrom through the conversion in the wavelength conversion substrate was measured in terms of intensity just after the start of irradiation and intensity 30 minutes after the start of irradiation, and evaluation was made of the amount of decrease in luminescence intensity due to the passage of time. In addition, the product was visually inspected for damage. As a result, the amount of decrease in luminescence intensity of the wavelength conversion element in this example was as small as 15%. Furthermore, no damage was found in the wavelength conversion element and its surrounding region.

### (Comparative Example)

A wavelength conversion element produced in the same manner as in the above example was bonded to a housing using an epoxy resin so that light was applied to the surface thereof at which the reflection suppression layer was formed. Thereafter, the resultant product was evaluated in the same manner as in the above example. As a result, the wavelength conversion element was damaged approximately 20 minutes after the start of irradiation.

**Reference Signs List**

| | |
|---|---|
| 1, 1a to 1c | light source |
| 2, 2a, 2b | backlight unit for liquid crystals |
| 10 | light-emitting element |
| 11 | dichroic mirror |
| 12 | housing |
| 12a | surface of housing |
| 12b | recess |
| 13 | solder layer |
| 20 | wavelength conversion element |
| 20a | surface of wavelength conversion element |
| 21 | wavelength conversion substrate |
| 21a | first principal surface |
| 21b | second principal surface |
| 22 | reflection suppression layer |
| 22H | high-refractive index layer |
| 22L | low-refractive index layer |
| 23 | adhesion layer |
| 24 | reflective layer |
| 25 | barrier layer |
| 26 | solder securing layer |
| 30 | light guide |
| 30a | side surface of light guide |
| 30b | principal surface of light guide |

## Claims

1. A wavelength conversion element comprising:
a wavelength conversion substrate that, upon incidence of excitation light, absorbs part of the excitation light to emit light of different wavelength from the excitation light; and
a reflective layer disposed on one surface of the wavelength conversion substrate and made of a metal or an alloy.

2. The wavelength conversion element according to claim 1, further comprising a reflection suppression layer formed on the other surface of the wavelength conversion substrate to suppress the reflection of light entering the wavelength conversion substrate from the other surface thereof.

3. The wavelength conversion element according to claim 2, wherein the reflection suppression layer is formed of a stack including a low-refractive index layer of relatively low refractive index and a high-refractive index layer of relatively high refractive index alternately stacked.

4. The wavelength conversion element according to any one of claims 1 to 3, wherein the reflective layer is made of a metal selected from the group consisting of Ag, Al, Au, Pd, and Ti or an alloy containing at least one metal selected from the group consisting of Ag, Al, Au, Pd, and Ti.

5. The wavelength conversion element according to any one of claims 1 to 4, further comprising an adhesion layer formed between the reflective layer and the wavelength conversion substrate to increase the adhesion strength between the reflective layer and the wavelength conversion substrate.

6. The wavelength conversion element according to claim 5, wherein the adhesion layer is made of aluminum oxide, chromium oxide, copper oxide, titanium, chromium or an alloy containing chromium.

7. The wavelength conversion element according to any one of claims 1 to 6, further comprising a solder securing layer formed on the reflective layer.

8. The wavelength conversion element according to claim 7, wherein the solder securing layer is made of Au, an alloy containing Au, Sn, an alloy containing Sn, In, an alloy containing In, Pb, an alloy containing Pb, Al, an alloy containing Al, Ag or an alloy containing Ag.

9. The wavelength conversion element according to claim 7 or 8, further comprising a barrier layer formed between the solder securing layer and the reflective layer and made of Ni, a Ni-Cr alloy, Pt or Pd.

10. The wavelength conversion element according to any one of claims 1 to 9, wherein the wavelength conversion substrate is made of a glass or ceramic containing inorganic phosphor powder dispersed therein.

11. A light source comprising:
the wavelength conversion element according to any one of claims 1 to 10; and
a light-emitting element for emitting excitation light to the other surface of the wavelength conversion substrate.

12. The light source according to claim 11, wherein the light-emitting element is formed of a semiconductor light-emitting element.

13. The light source according to claim 11 or 12, wherein
the wavelength conversion element further comprises a solder securing layer formed on the reflective layer and made of Au, an alloy containing Au, Sn or an alloy containing Sn, and
the light source further comprises:
a housing; and
a solder layer that bonds the housing and the solder securing layer of the wavelength conversion substrate together.

14. A backlight unit for liquid crystals, comprising:
the light source according to any one of claims 11 to 13; and
a light guide that includes a principal surface and a side surface, receives on the side surface light from the wavelength conversion element, and emits area light from the principal surface.
